# EUROPEAN PATENT SPECIFICATION

(11) **EP 3 255 684 B1**
(45) Date of publication and mention of the grant of the patent: **09.09.2020**
(21) Application number: 15881138.0
(22) Date of filing: 10.06.2015
(51) Int. Cl.: H01L 33/38, H01L 21/28, H01L 29/41, H01L 33/02, H01L 33/20, H01L 33/44

(54) **SEMICONDUCTOR LIGHT EMITTING ELEMENT**
LICHTEMITTIERENDES HALBLEITERELEMENT
ÉLÉMENT ÉLECTROLUMINESCENT SEMI-CONDUCTEUR

(30) Priority: 06.02.2015 JP 2015022121
(43) Date of publication of application: 13.12.2017
(73) Proprietor: Samsung Electronics Co., Ltd., Suwon-si, Gyeonggi-do 16677 (KR)
(72) Inventor: ONO, Hiroshi, Tokyo 105-8001 (JP); TAJIMA, Jumpei, Tokyo 105-8001 (JP); NUNOUE, Shinya, Tokyo 105-8001 (JP)
(74) Representative: Kuhnen & Wacker Patent- und Rechtsanwaltsbüro PartG mbB
(86) International application number: PCT/JP2015/066766
(87) International publication number: WO 2016/125321

(56) References cited:
- EP-A2- 2 525 420
- EP-A2- 2 822 034
- DE-A1-102013 103 079
- JP-A- 2010 027 643
- JP-A- 2011 066 048
- JP-A- 2013 065 726
- JP-A- 2013 211 595
- JP-A- 2014 038 920
- JP-A- 2014 041 999
- JP-A- 2014 044 971
- JP-A- 2014 045 226
- JP-A- 2014 216 470
- US-A1- 2012 074 441
- US-A1- 2014 048 816
- US-A1- 2014 054 594
- US-A1- 2014 061 703

## Description

### [Technical Field]

Embodiments described herein relate generally to a semiconductor light-emitting element and a method for manufacturing the same.

### [Background Art]

There is a configuration of a semiconductor light-emitting element such as an LED (Light Emitting Diode), etc., in which a semiconductor layer is grown on a substrate; subsequently, the substrate is removed; and the semiconductor layer is bonded to another support body. Stable operations of such a semiconductor light-emitting element are desirable.

### [Citation List]

### [Patent Literature]

### [Patent Literature 1]

JP 2010-517274 A Semiconductor light-emitting elements are also disclosed in documents US 2014 0054594 A1, DE 10 2013 103 079 A1 and US 2012 0074441 A1.

### [Summary of Invention]

### [Problem to be Solved by the Invention]

Embodiments of the invention provide a semiconductor light-emitting element in which stable operations are possible. Disclosed is a method for manufacturing the semiconductor light-emitting element.

### [Means for Solving the Problem]

According to an embodiment of the invention, as defined in claim 1, a semiconductor light-emitting element includes a base body, a first semiconductor layer, a second semiconductor layer, a third semiconductor layer, a first conductive layer, and a first insulating portion. The base body has a first surface including an outer edge region and an inner region on an inner side of the outer edge region, and a base body side surface intersecting the first surface. The first semiconductor layer is of a first conductivity type. The second semiconductor layer is of a second conductivity type and is provided between the first semiconductor layer and at least a portion of the inner region. The third semiconductor layer is provided between the first semiconductor layer and the second semiconductor layer. A portion of the first conductive layer is provided between the base body and the second semiconductor layer. The first insulating portion overlaps the outer edge region in a first direction, where the first direction is from the second semiconductor layer toward the first semiconductor layer. A thickness of the first insulating portion at a position overlapping the base body side surface in the first direction is thicker than a thickness of the first insulating portion at a position separated from the base body side surface in a direction intersecting the first direction. The first insulating portion includes: a first portion overlapping the outer edge region in the first direction and overlapping the second semiconductor layer in a second direction perpendicular to the first direction; and a second portion overlapping the outer edge region in the first direction and overlapping the first conductive layer in the second direction, wherein at least a portion of the second portion of the first insulating portion contacts the base body. The first portion includes: a first outer side surface aligned with a second surface, the second surface including the base body side surface and intersecting a plane parallel to the first surface; and a first inner side surface opposing the second semiconductor layer and intersecting the plane. The second portion includes: a second outer side surface aligned with the second surface; and a second inner side surface opposing the first conductive layer and intersecting the plane, and a first distance between the first outer side surface and the first inner side surface is longer than a second distance between the second outer side surface and the second inner side surface, wherein a thickness of the second portion along the first direction of the second portion is not less than 1.5 times and not more than 10 times a thickness of the first portion along the first direction of the first portion, and the absolute value of a difference between the first distance and the second distance is not less than 2 times and not more than 10 times the thickness of the second portion along the first direction of the second portion.

Further preferred embodiments are defined in the dependent claims.

### [Brief Description of Drawings]

[FIG. 1]

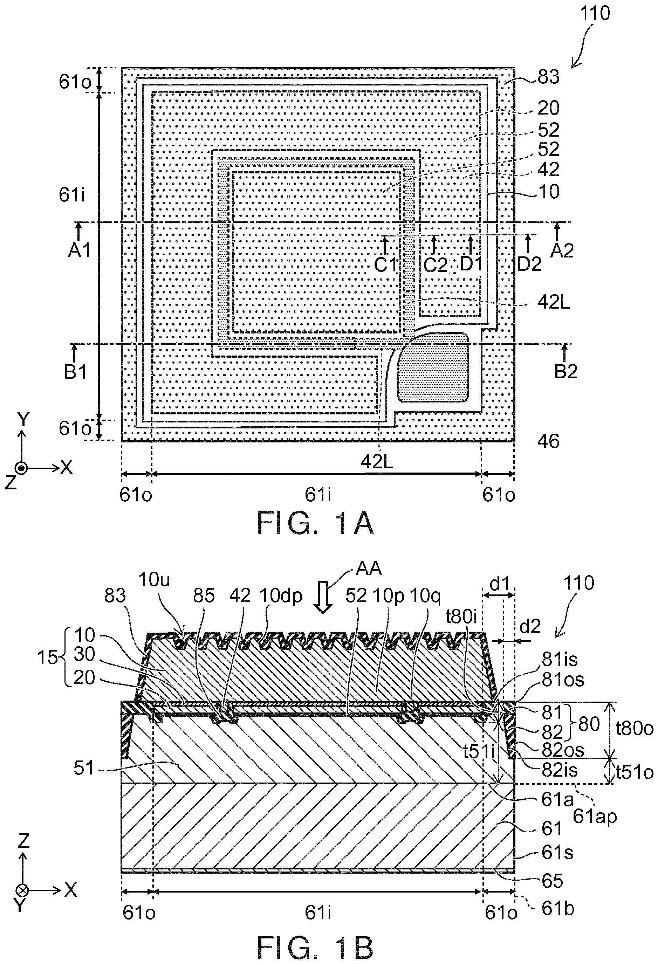

   FIG. 1A and FIG. 1B are schematic views showing a semiconductor light-emitting element according to a first embodiment.
[FIG. 2]

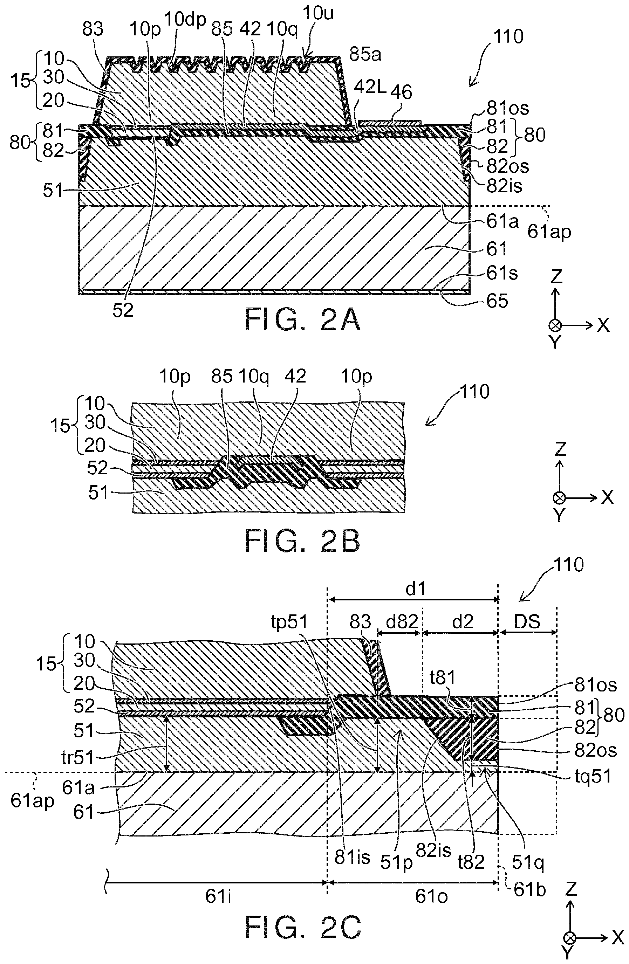

   FIG. 2A to FIG. 2C are schematic cross-sectional views showing the semiconductor light-emitting element according to the first embodiment.
[FIG. 3]

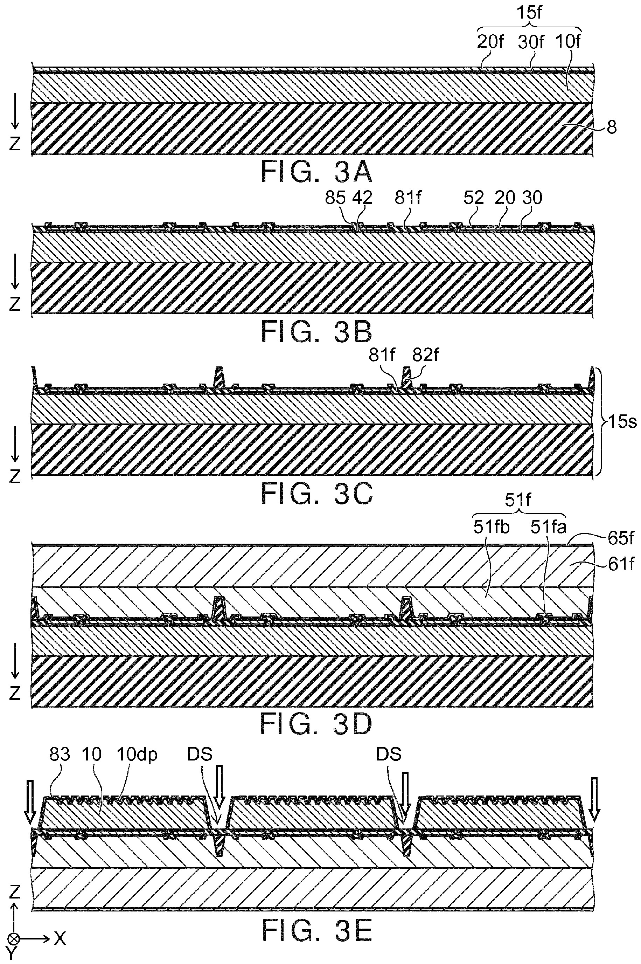

   FIG. 3A to FIG. 3E are schematic cross-sectional views in order of the processes, showing a method for manufacturing the semiconductor light-emitting element according to the first embodiment.
[FIG. 4]

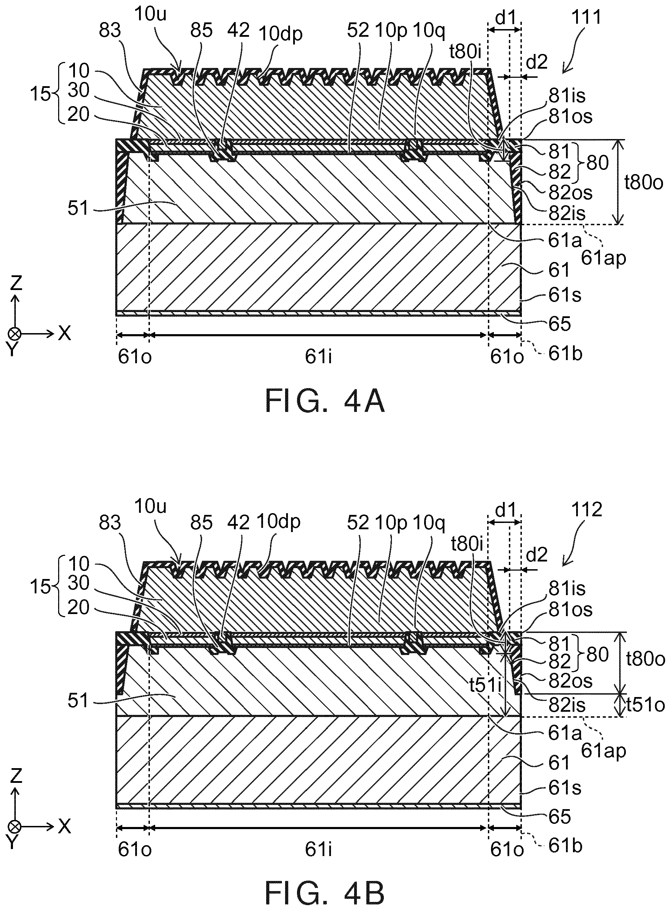

   FIG. 4A and FIG. 4B are schematic cross-sectional views showing other semiconductor light-emitting elements according to the first embodiment.
[FIG. 5]

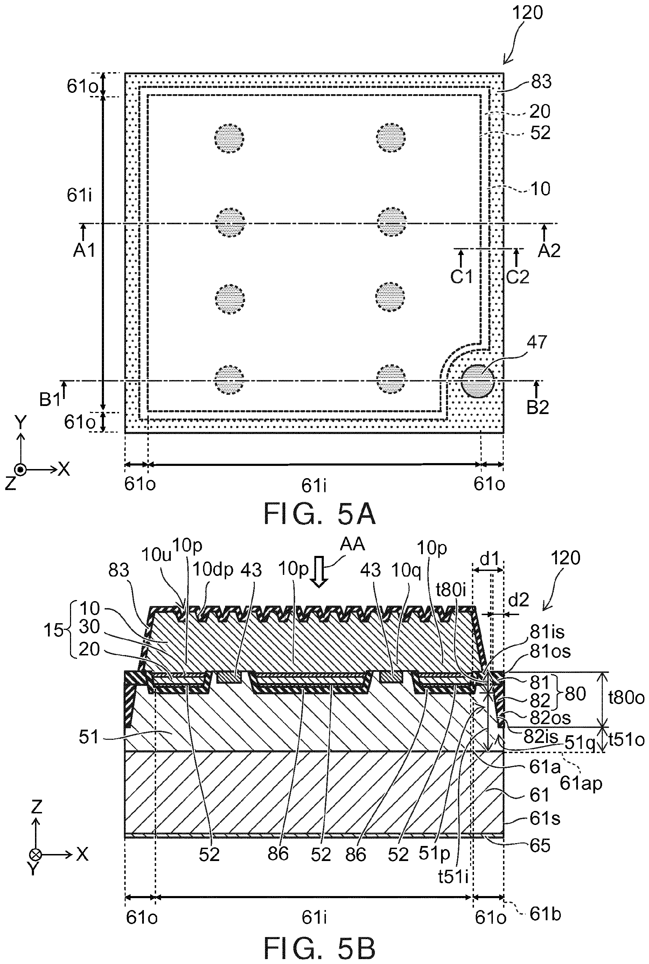

   FIG. 5A and FIG. 5B are schematic views showing a semiconductor light-emitting element according to a second embodiment.
[FIG. 6]

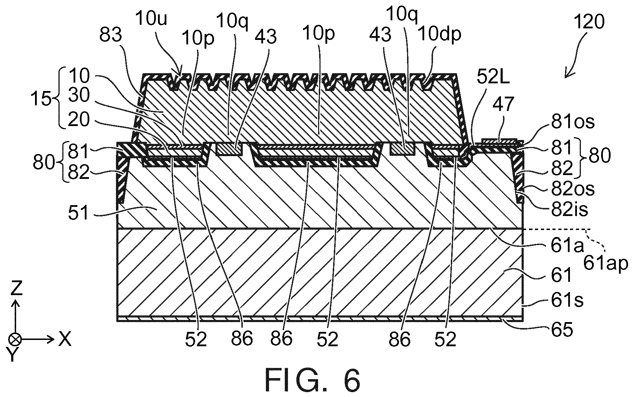

   FIG. 6 is a schematic cross-sectional view showing the semiconductor light-emitting element according to the second embodiment.
[FIG. 7]

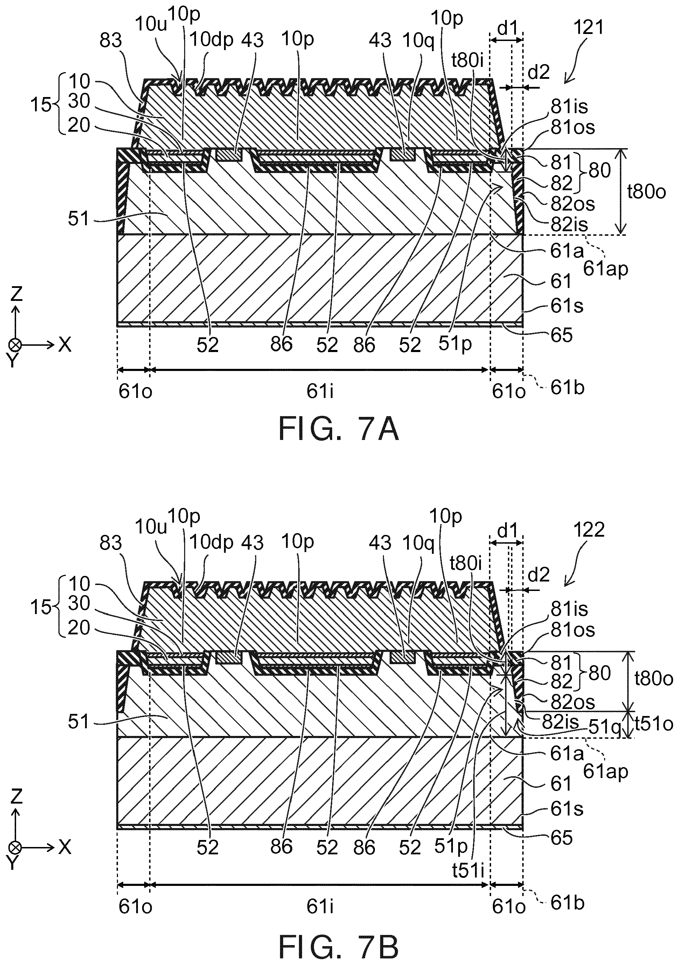

   FIG. 7A and FIG. 7B are schematic cross-sectional views showing other semiconductor light-emitting elements according to the second embodiment.
[FIG. 8]

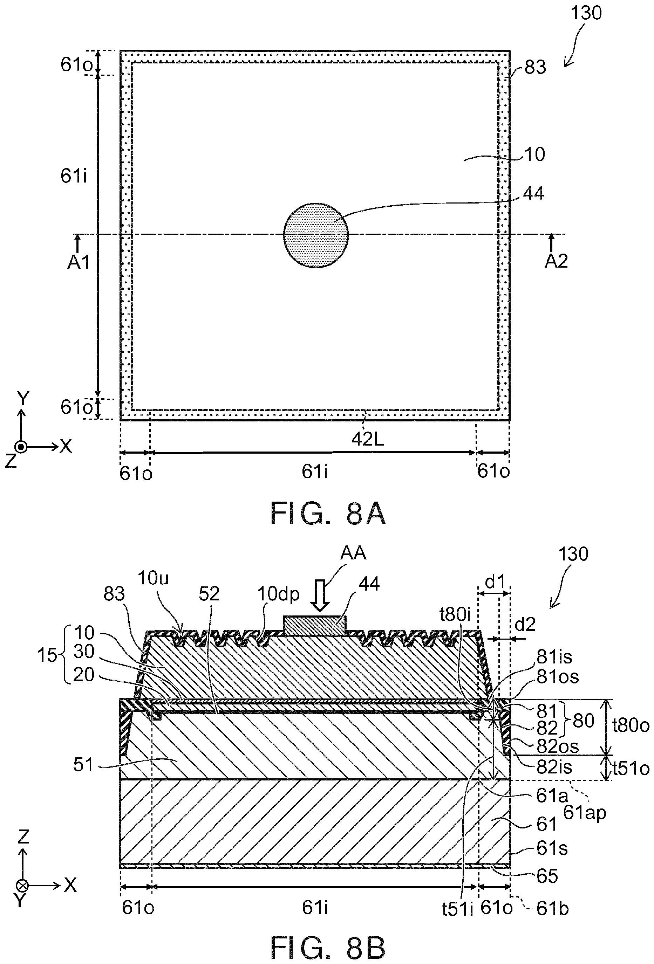

   FIG. 8A and FIG. 8B are schematic views showing a semiconductor light-emitting element according to a third embodiment.
[FIG. 9]

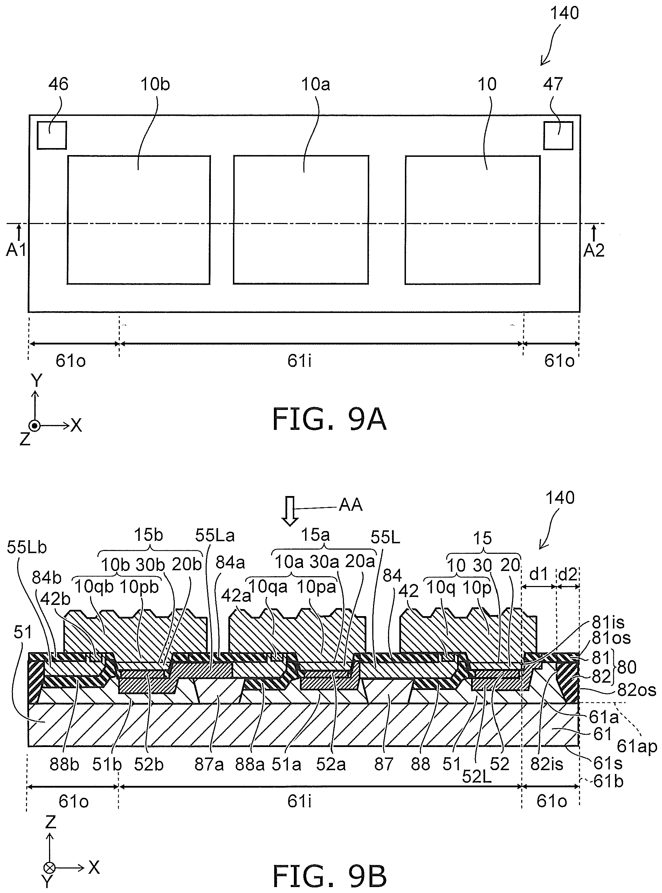

   FIG. 9A and FIG. 9B are schematic views showing a semiconductor light-emitting element according to a fourth embodiment.
[FIG. 10]

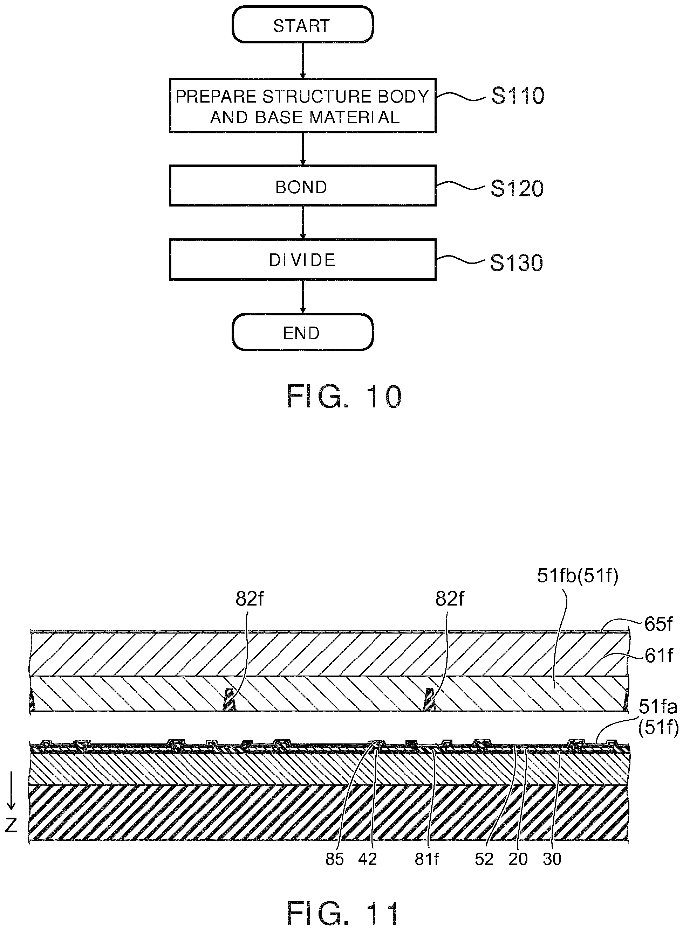

   FIG. 10 is a flowchart showing a method for manufacturing a semiconductor light-emitting element according to a fifth embodiment.
[FIG. 11]
   FIG. 11 is a schematic cross-sectional view showing the method for manufacturing the semiconductor light-emitting element according to the fifth embodiment.

### [Description of Embodiments]

Various embodiments will be described hereinafter with reference to the accompanying drawings.

The drawings are schematic and conceptual; and the relationships between the thickness and width of portions, the proportions of sizes among portions, etc., are not necessarily the same as the actual values thereof. Further, the dimensions and proportions may be illustrated differently among drawings, even for identical portions.

In the specification and drawings, components similar to those described or illustrated in a drawing thereinabove are marked with like reference numerals, and a detailed description is omitted as appropriate.

### (First embodiment)

FIG. 1A and FIG. 1B are schematic views illustrating a semiconductor light-emitting element according to the first embodiment.

FIG. 1B is a line A1-A2 cross-sectional view of FIG. 1A. FIG. 1A is a plan view as viewed from the direction of arrow AA shown in FIG. 1B.

FIG. 2A to FIG. 2C are schematic cross-sectional views illustrating the semiconductor light-emitting element according to the first embodiment.

FIG. 2A is a line B1-B2 cross-sectional view of FIG. 1A. FIG. 2B is a line C1-C2 cross-sectional view of FIG. 1A. FIG. 2C is a line D1-D2 cross-sectional view of FIG. 1A.

As shown in FIG. 1A and FIG. 1B, the semiconductor light-emitting element 110 according to the embodiment includes a base body 61, a first semiconductor layer 10, a second semiconductor layer 20, a third semiconductor layer 30, a first conductive layer 51, and a first insulating portion 80.

The base body 61 has a first surface 61a and a base body side surface 61s. The base body side surface 61s intersects the first surface 61a. The first surface 61a includes an outer edge region 61o and an inner region 61i. The inner region 61i is on the inner side of the outer edge region 61o.

The first semiconductor layer 10 is of a first conductivity type.

The second semiconductor layer 20 is provided between the first semiconductor layer 10 and at least a portion of the inner region 61i. The second semiconductor layer 20 is of a second conductivity type.

For example, the first conductivity type is an n-type; and the second conductivity type is a p-type. In the embodiment, the first conductivity type may be the p-type; and the second conductivity type may be the n-type. In the example below, the first conductivity type is the n-type; and the second conductivity type is the p-type.

The third semiconductor layer 30 is provided between the first semiconductor layer 10 and the second semiconductor layer 20. The third semiconductor layer 30 in the claimed invention is a light-emitting layer.

The first semiconductor layer 10, the second semiconductor layer 20, and the third semiconductor layer 30 are included in a stacked body 15 of semiconductors.

A direction from the second semiconductor layer 20 toward the first semiconductor layer 10 is taken as a Z-axis direction (a first direction). One direction perpendicular to the Z-axis direction is taken as an X-axis direction. A direction perpendicular to the Z-axis direction and the X-axis direction is taken as a Y-axis direction. For example, the first surface 61a is substantially perpendicular to the X-Y plane.

A portion of the first conductive layer 51 is provided between the base body 61 and the second semiconductor layer 20. A portion of the first conductive layer 51 is provided between the base body 61 and the stacked body 15.

The first insulating portion 80 overlaps the outer edge region 61o in the Z-axis direction (the first direction from the second semiconductor layer 20 toward the first semiconductor layer 10). The first insulating portion 80 includes a first portion 81 and a second portion 82. The first portion 81 overlaps the outer edge region 61o in the first direction (the Z-axis direction from the second semiconductor layer 20 toward the first semiconductor layer 10). The first portion 81 overlaps the second semiconductor layer 20 in a second direction perpendicular to the first direction. For example, the second direction is the X-axis direction. The first portion 81 may overlap the third semiconductor layer 30 in the X-axis direction. The first portion 81 may overlap a portion of the first semiconductor layer 10 in the X-axis direction.

The second portion 82 overlaps the outer edge region 61o in the first direction (the Z-axis direction); and the second portion 82 overlaps the first conductive layer 51 in the second direction (e.g., the X-axis direction).

In other words, for example, the first conductive layer 51 is provided on the base body 61. The second portion 82 of the first insulating portion 80 is provided at a position overlapping the outer edge region 61o of the base body 61 on the first conductive layer 51. For example, a portion of the first portion 81 contacts the first conductive layer 51 on the first conductive layer 51. For example, another portion of the first portion 81 contacts the second portion 82 on the second portion 82.

The first portion 81 has a first outer side surface 81os and a first inner side surface 81is. The first outer side surface 81os is aligned with a second surface 61b. The second surface 61b intersects a plane 61ap (e.g., the X-Y plane) parallel to the first surface 61a and includes the base body side surface 61s. The second surface 61b is parallel to the base body side surface 61s. For example, the first outer side surface 81os is positioned on an extension of the base body side surface 61s.

The first inner side surface 81is intersects the plane 61ap (e.g., the X-Y plane) parallel to the first surface 61a and opposes the second semiconductor layer 20. For example, the second semiconductor layer 20 has a side surface intersecting the X-Y plane. The first inner side surface 81is is aligned with the side surface of the second semiconductor layer 20. For example, the first inner side surface 81is contacts the side surface of the second semiconductor layer 20.

The second portion 82 has a second outer side surface 82os and a second inner side surface 82is. The second outer side surface 82os is aligned with the second surface 61b recited above. For example, the second outer side surface 82os is positioned on an extension of the base body side surface 61s.

The second inner side surface 82is intersects the plane 61ap (e.g., the X-Y plane) parallel to the first surface 61a and opposes the first conductive layer 51. A portion of the first conductive layer 51 has a side surface intersecting the X-Y plane. The second inner side surface 82is is aligned with at least a portion of the side surface of the first conductive layer 51. The second inner side surface 82is contacts at least a portion of the side surface of the first conductive layer 51.

A first distance d1 between the first outer side surface 81os and the first inner side surface 81is is longer than a second distance d2 between the second outer side surface 82os and the second inner side surface 82is.

In other words, at least a portion of the first portion 81 of the first insulating portion 80 is positioned higher than the second portion 82 of the first insulating portion 80. The distance between the base body 61 and at least a portion of the first portion 81 is longer than the distance between the base body 61 and at least a portion of the second portion 82. Also, in the X-Y plane, the first inner side surface 81is of the first portion 81 is positioned on the inner side of the second inner side surface 82is of the second portion 82. The distance along the X-axis direction between the first inner side surface 81is and the base body side surface 61s is longer than the distance along the X-axis direction between the second inner side surface 82is and the base body side surface 61s.

For example, a level difference is formed in the first insulating portion 80 at the boundary portion between the first portion 81 and the second portion 82. The thickness (the length along the Z-axis direction) of the first insulating portion 80 in the region including the first outer side surface 81os and the second outer side surface 82os is thicker than the thickness (the length along the Z-axis direction) of the first insulating portion 80 in the region including the first inner side surface 81is. The thickness (an insulating portion outer edge thickness t80o) of the first insulating portion 80 at a position overlapping the base body side surface 61s in the Z-axis direction is thicker than the thickness (an insulating portion inner thickness t80i) of the first insulating portion 80 at a position separated from the base body side surface 61s in a direction intersecting the X-axis direction (e.g., in the X-Y plane). The insulating portion outer edge thickness t80o and the insulating portion inner thickness t80i are lengths along the Z-axis direction. The insulating portion outer edge thickness t80o is, for example, the thickness of the first insulating portion 80 at a position on an extension of the base body side surface 61s.

The thickness (a conductive portion outer edge thickness t51o) of the first conductive layer 51 at a position overlapping the base body side surface 61s in the Z-axis direction is thinner than the thickness (a conductive portion inner thickness t51i) of the first conductive layer 51 at a position separated from the base body side surface 61s in a direction intersecting the Z-axis direction (e.g., in the X-Y plane). The conductive portion outer edge thickness t51o is, for example, the thickness of the first conductive layer 51 at a position on an extension of the base body side surface 61s. Or, the conductive portion outer edge thickness t51o of the first conductive layer 51 may be zero. In other words, in an embodiment of the claimed invention, at least a portion of the second portion 82 contacts the base body 61. The conductive portion outer edge thickness t51o and the conductive portion inner thickness t51i are lengths along the Z-axis direction.

The conductive portion outer edge thickness t51o becomes thinner than the conductive portion inner thickness t51i in the first conductive layer 51 because the insulating portion outer edge thickness t80o is thicker than the insulating portion inner edge thickness t80i. Thereby, the exposed surface area of the first conductive layer 51 is small at the outer edge portion of the semiconductor light-emitting element 110. The first conductive layer 51 is not exposed at the outer edge portion of the semiconductor light-emitting element 110 by the conductive portion outer edge thickness t51o of the first conductive layer 51 being zero. Thereby, peeling (breaking away) from the semiconductor light-emitting element 110 of a portion (a fragment, etc.) of the conductive member used to form the first conductive layer 51 can be suppressed.

When a portion (a fragment, etc.) of the conductive member peels, there are cases where electrical shorts of the semiconductor light-emitting element 110 occur and normal operations are not obtained. Or, the reliability decreases.

In the embodiment, the peeling (the breaking away, etc.) of the portion (the fragment, etc.) of the conductive member can be suppressed by the conductive portion outer edge thickness t51o being thinner than the conductive portion inner thickness t51i or by the conductive portion outer edge thickness t51o being zero in the first conductive layer 51. Thereby, a semiconductor light-emitting element can be provided in which stable operations are possible.

In the example, the second portion 82 does not overlap the second semiconductor layer 20 in the second direction (e.g., the X-axis direction) recited above. In the embodiment, a portion of the second portion 82 may overlap the second semiconductor layer 20 in the second direction (e.g., the X-axis direction) recited above.

For example, the second portion 82 does not overlap the third semiconductor layer 30 in the second direction (e.g., the X-axis direction) recited above.

The semiconductor light-emitting element 110 further includes a second conductive layer 42, a second insulating portion 85, a pad portion 46, a first interconnect 42L, a first interconnect insulating film 85a, an electrode layer 52, a base body electrode layer 65, and an insulating film 83.

The first semiconductor layer 10 includes a first semiconductor region 10p and a second semiconductor region 10q. The second semiconductor region 10q is arranged with the first semiconductor region 10p in a direction (e.g., the X-axis direction, etc.) intersecting the first direction (the Z-axis direction). The second semiconductor layer 20 overlaps the first semiconductor region 10p in the first direction (the Z-axis direction). In other words, the second semiconductor layer 20 is provided between the first semiconductor region 10p of the first semiconductor layer 10 and the first conductive layer 51.

The second conductive layer 42 is provided between the second semiconductor region 10q and the first conductive layer 51. The second conductive layer 42 is electrically connected to the second semiconductor region 10q. The second conductive layer 42 is, for example, an n-side electrode.

The second insulating portion 85 is provided between the second conductive layer 42 and the first conductive layer 51.

As shown in FIG. 2A, at least a portion of the first insulating portion 80 is disposed between the pad portion 46 and the first conductive layer 51. For example, at least a portion of the first portion 81 of the first insulating portion 80 is disposed between the pad portion 46 and the first conductive layer 51.

The first interconnect 42L electrically connects the pad portion 46 and the first semiconductor layer 10. In the example, the first interconnect 42L is continuous with the second conductive layer 42. The conductive layer that is used to form the first interconnect 42L and the second conductive layer 42 includes a portion separated from the second semiconductor region 10q of the first semiconductor layer 10. The portion of the conductive layer recited above is used to form the first interconnect 42L.

The first interconnect insulating film 85a is provided between the first interconnect 42L and a portion of the second semiconductor region 10q of the first semiconductor layer 10.

The electrode layer 52 is provided between the second semiconductor layer 20 and the first conductive layer 51. The electrode layer 52 is electrically connected to the second semiconductor layer 20 and the first conductive layer 51. The electrode layer 52 is, for example, a p-side electrode.

The base body 61, the first conductive layer 51, the second semiconductor layer 20, and the third semiconductor layer 30 are provided between the base body electrode layer 65 and the first semiconductor layer 10.

For example, the base body 61 is conductive. The first conductive layer 51 electrically connects the second semiconductor layer 20 and the base body 61.

The insulating film 83 is provided on the side surface (the surface intersecting the X-Y plane) of the stacked body 15. The insulating film 83 is, for example, a protective film.

In the example, an unevenness 10dp is provided in one surface (an upper surface 10u) of the first semiconductor layer 10. The first semiconductor layer 10 has a surface opposing the third semiconductor layer 30. The upper surface 10u is a surface on the side opposite to the surface opposing the third semiconductor layer 30. The insulating film 83 covers the unevenness 10dp.

A voltage is applied between the base body electrode layer 65 and the pad portion 46. A current is supplied to the third semiconductor layer 30 via the base body electrode layer 65, the first conductive layer 51, the electrode layer 52, the second semiconductor layer 20, the pad portion 46, the first interconnect 42L, the second conductive layer 42, and the first semiconductor layer 10. Light is emitted in the third semiconductor layer 30. The emitted light is emitted from the upper surface 10u of the first semiconductor layer 10.

The semiconductor light-emitting element 110 is, for example, an LED. The semiconductor light-emitting element 110 is, for example, a lateral-conduction LED. In the semiconductor light-emitting element 110, the pad portion 46 is an electric terminal on the first conductivity-type side (the n-side); and the base body electrode layer 65 is an electric terminal on the second conductivity-type side (the p-side).

As shown in FIG. 2B, the second semiconductor region 10q is provided between two first semiconductor regions 10p. In the example, the second insulating portion 85 contacts a portion of the first semiconductor layer 10, the side surface of the third semiconductor layer 30, the side surface of the second semiconductor layer 20, the side surface of the electrode layer 52, the second conductive layer 42, and the first conductive layer 51. Also, a portion of the second insulating portion 85 is provided between the first conductive layer 51 and a portion of the electrode layer 52.

As shown in FIG. 2C, the first conductive layer 51 includes a first conductive region 51p and a second conductive region 51q. The first conductive region 51p is positioned between the first portion 81 and the base body 61. The first conductive region 51p does not overlap the second portion 82 in the first direction (the Z-axis direction). The second conductive region 51q is positioned between the second portion 82 and the base body 61.

A first conductive region thickness tp51 along the first direction of the first conductive region 51p is thicker than a second conductive region thickness tq51 along the first direction of the second conductive region 51q. The first conductive region thickness tp51 is not less than 2 times and not more than 50 times the second conductive region thickness tq51.

The first conductive region thickness tp51 is, for example, not less than 0.5 µm (micrometers) and not more than 5 µm. The first conductive region thickness tp51 is, for example, about 1.5 µm.

The second conductive region thickness tq51 is, for example, not less than 0.05 µm and not more than 1 µm.

For example, the first conductive region thickness tp51 may be the same as the conductive portion inner thickness t51i described above (the thickness at the position separated from the base body side surface 61s). For example, the second conductive region thickness tq51 may be the same as the conductive portion outer edge thickness t51o described above (the thickness at the position overlapping the base body side surface 61s).

As described above, in an embodiment of the claimed invention, at least a portion of the second portion 82 contacts the base body 61. In such a case, the second conductive region thickness tq51 is substantially zero.

A second insulating portion thickness t82 along the first direction of the second portion 82 is not less than 1.5 times and not more than 10 times a first insulating portion thickness t81 along the first direction of the first portion 81.

The second insulating portion thickness t82 is, for example, not less than 1 µm and not more than 5 µm.

The first insulating portion thickness t81 is, for example, not less than 0.5 µm and not more than 3 µm. The first insulating portion thickness t81 is, for example, about 1 µm.

The total of the first insulating portion thickness t81 and the second insulating portion thickness t82 may be the same as, for example, the insulating portion outer edge thickness t80o. The first insulating portion thickness t81 may be used as the insulating portion inner thickness t80i.

It is favorable for the second conductive region thickness tq51 to be thinner than the second insulating portion thickness t82. For example, the second conductive region thickness tq51 exceeds 1 times and is not more than 50 times the second insulating portion thickness t82.

In the example, the first conductive layer 51 includes a portion overlapping the second semiconductor layer 20 in the first direction. A thickness tr51 (the length along the first direction) of the portion of the first conductive layer 51 overlapping the second semiconductor layer 20 in the first direction is, for example, not less than 1 µm and not more than 5 µm. The thickness tr51 is, for example, about 2 µm or more.

For example, the first distance d1 between the first outer side surface 81os and the first inner side surface 81is is not less than 2 times and not more than 20 times the second distance d2 between the second outer side surface 82os and the second inner side surface 82is.

The first distance d1 is, for example, not less than 5 µm and not more than 30 µm. The second distance d2 is, for example, not less than 1 µm and not more than 10 µm.

In an embodiment of the claimed invention the absolute value of the difference between the first distance d1 and the second distance d2 is not less than 2 times and not more than 10 times the second insulating portion thickness t82.

The first inner side surface 81is may be tilted with respect to the X-Y plane. The first inner side surface 81is may have a tapered configuration. In such a case, the first distance d1 between the first outer side surface 81os and the first inner side surface 81is is the distance along the X-axis direction between the first outer side surface 81os and the position of the center in the Z-axis direction of the first inner side surface 81is.

There are cases where the first outer side surface 81os includes recesses and protrusions. The position in the X-Y plane at the recesses is different from the position in the X-Y plane at the protrusions. In such a case, for example, the position of the center of the recesses and protrusions is used as the position in the X-Y plane of the first outer side surface 81os. For example, the average position in the X-Y plane of the first outer side surface 81os including the recesses and protrusions may be used as the position in the X-Y plane of the first outer side surface 81os.

The second inner side surface 82is may be tilted with respect to the X-Y plane. The second inner side surface 82is may have a tapered configuration. In such a case, the second distance d2 between the second outer side surface 82os and the second inner side surface 82is is the distance along the X-axis direction between the second outer side surface 82os and the position of the center in the Z-axis direction of the second inner side surface 82is.

There are cases where the second outer side surface 82os includes recesses and protrusions. The position in the X-Y plane at the recesses is different from the position in the X-Y plane at the protrusions. In such a case, for example, the position of the center of the recesses and protrusions is used as the position in the X-Y plane of the second outer side surface 82os. For example, the average position in the X-Y plane of the second outer side surface 82os including the recesses and protrusions may be used as the position in the X-Y plane of the second outer side surface 82os.

A distance d82 between the second portion 82 and the outer edge of the first semiconductor layer 10 is, for example, not less than 1 µm and not more than 8 µm.

As described below, a structure body that is used to form the multiple semiconductor light-emitting elements 110 is formed on a substrate (a wafer). Then, the multiple semiconductor light-emitting elements 110 are formed by separating the multiple structure bodies. A dicing street DS for the separating is provided. The width (the length along a direction aligned with the X-Y plane) of the dicing street DS is, for example, about 70 µm (e.g., not less than 50 µm and not more than 150 µm).

The thickness of the insulating film 83 is, for example, not less than 100 nm (nanometers) and not more than 400 nm.

The first semiconductor layer 10, the second semiconductor layer 20, and the third semiconductor layer 30 include, for example, nitride semiconductors. In the embodiment, the materials of these semiconductor layers are arbitrary.

The first semiconductor layer 10 includes, for example, an n-type GaN layer. The second semiconductor layer 20 includes, for example, a p-type GaN layer. The third semiconductor layer 30 includes, for example, a well layer of an InGaN layer. The third semiconductor layer 30 may include multiple barrier layers (e.g., a GaN layer, an AIGaN layer, etc.). A well layer is disposed between the multiple barrier layers. The number of well layers may be of one, two, or more.

The first conductive layer 51 includes, for example, a metal. The first conductive layer 51 includes at least one of Au, Sn, AuSn, or NiSn. For example, a AuSn alloy is used as the first conductive layer 51.

In the case where the base body 61 is conductive, the base body 61 includes, for example, a silicon substrate, a metal layer, etc. In the case where the base body 61 is insulative, the base body 61 includes, for example, a ceramic substrate (e.g., an AIN substrate, a SiN substrate, etc.), etc.

The first insulating portion 80 includes, for example, silicon oxide, silicon nitride, or silicon oxynitride. For example, a metal oxide, a metal nitride, or a metal oxynitride may be used as the first insulating portion 80. In such a case, for example, Al or the like is used as the metal.

The second conductive layer 42 includes, for example, at least one of aluminum, tantalum, titanium, silver, or platinum. The second conductive layer 42 may include, for example, an alloy including at least one of aluminum, tantalum, titanium, silver, or platinum.

The first interconnect 42L includes, for example, the same material as the material of at least a portion of the second conductive layer 42.

The pad portion 46 includes at least one of titanium, platinum, or gold. The thickness of the pad portion 46 is, for example, about 0.4 µm (e.g., not less than 0.2 µm and not more than 1 µm).

The electrode layer 52 includes, for example, at least one of silver, nickel, platinum, or titanium. The electrode layer 52 may include, for example, an alloy including at least one of silver, nickel, platinum, or titanium.

The base body electrode layer 65 includes, for example, at least one of titanium, platinum, or gold.

At least one of the second insulating portion 85, the first interconnect insulating film 85a, or the insulating film 83 includes silicon oxide, silicon nitride, or silicon oxynitride. For example, a metal oxide, a metal nitride, or a metal oxynitride may be used as at least one of the second insulating portion 85, the first interconnect insulating film 85a, or the insulating film 83. In such a case, for example, Al or the like is used as the metal.

An example of a method for manufacturing the semiconductor light-emitting element 110 will now be described.

FIG. 3A to FIG. 3E are schematic cross-sectional views in order of the processes, illustrating the method for manufacturing the semiconductor light-emitting element according to the first embodiment.

As shown in FIG. 3A, a first semiconductor film 10f that is used to form the first semiconductor layer 10, a third semiconductor film 30f that is used to form the third semiconductor layer 30, and a second semiconductor film 20f that is used to form the second semiconductor layer 20 are formed in this order on a substrate 8. Thereby, a stacked film 15f that is used to form the stacked body 15 is formed. The forming of these films includes, for example, epitaxial crystal growth such as metal-organic chemical vapor deposition (MOCVD: Metal Organic Chemical Vapor Deposition), molecular beam epitaxy (MBE: Molecular Beam Epitaxy), etc.

For example, a silicon substrate, a sapphire substrate (e.g., a c-plane sapphire substrate), a GaN substrate, a SiC substrate, a ZnO substrate, or the like is used as the substrate 8. A buffer layer, etc., may be formed between the substrate 8 and the first semiconductor film 10f.

A portion of the second semiconductor film 20f and a portion of the third semiconductor film 30f are removed as shown in FIG. 3B. Thereby, the second semiconductor layer 20 and the third semiconductor layer are formed. The second semiconductor layer 20 and the third semiconductor layer are formed at positions corresponding to each of the multiple semiconductor light-emitting elements 110. The second conductive layer 42 is formed on the first semiconductor film 10f exposed by the removal.

For example, processing (e.g., RIE: Reactive Ion Etching) processing of the surface of the first semiconductor layer 10 where the second conductive layer 42 is formed is performed in a gas atmosphere including chlorine. Thereby, a low contact resistance is obtained.

The second insulating portion 85 is formed on the second conductive layer 42. The electrode layer 52 is formed on the second semiconductor layer 20. A first portion film 81f that is used to form the first portion 81 of the first insulating portion 80 is formed along the outer edges of the regions used to form the multiple semiconductor light-emitting elements 110. The first interconnect insulating film 85a and the first interconnect 42L also are formed in this process. For example, CVD (Chemical Vapor Deposition) or sputtering is used to form the first portion film 81f. SOG (Spin On Glass) may be used to form the first portion film 81f. For example, wet etching or dry etching is used to pattern the first portion film 81f.

As shown in FIG. 3C, a second portion film 82f that is used to form the second portion 82 of the first insulating portion 80 is formed on a portion of the first portion film 81f. For example, CVD or sputtering is used to form the second portion film 82f. SOG may be used to form the second portion film 82f. For example, wet etching or dry etching is used to pattern the configuration of the second portion film 82f.

Thereby, a structure body 15s is formed, the structure body 15s includes the stacked film 15f and the first portion film 81f. In the example, the structure body 15s further includes the second portion film 82f.

As shown in FIG. 3D, a metal film 51fa that is used to form a portion of the first conductive layer 51 is formed on the electrode layer 52, the second insulating portion 85, the first portion film 81f, and the second portion film 82f. The metal film 51fa includes, for example, a stacked film of TiW/Pt. The metal film 51fa may include at least one of a titanium film or a gold film. For example, sputtering or the like is used to form the metal film 51fa. A portion of a metal film 51fb may be provided on the metal film 51fa.

On the other hand, a base material 61f that is used to form the base body 61 is prepared. An electrode film 65f that is used to form the base body electrode layer 65 is provided on one surface of the base material 61f. At least a portion of the metal film 51fb used to form a portion of the first conductive layer 51 is provided on another surface of the base material 61f.

The metal film 51fa and at least a portion of the metal film 51fb provided on the base material 61f are caused to contact each other; and bonding is performed. For example, bonding is performed by melting the metal film 51fb by heating to about 230 °C. The metal film 51fa and the metal film 51fb become a first conductive film 51f used to form the first conductive layer 51.

The substrate 8 is removed as shown in FIG. 3E. The first semiconductor layer 10 is obtained by patterning the first semiconductor film 10f exposed by the removal. The multiple first semiconductor layers 10 are formed to correspond to the multiple semiconductor light-emitting elements 110. The unevenness 10dp is formed as appropriate. The insulating film 83 is formed.

The first portion film 81f, the second portion film 82f, the first conductive film 51f, the base material 61f, and the electrode film 65f are divided at the dicing street DS between the multiple semiconductor light-emitting elements 110. For example, a dicing saw, laser dicing, or the like is used in the dividing. The first portion 81 of the first insulating portion 80, the second portion 82 of the first insulating portion 80, the first conductive layer 51, the base body 61, and the base body electrode layer 65 are obtained by the dividing. Thereby, the multiple semiconductor light-emitting elements 110 are obtained.

The base body side surface 61s of the base body 61 is formed by the dividing recited above. Also, the first outer side surface 81os of the first portion 81 of the first insulating portion 80 and the second outer side surface 82os of the second portion 82 of the first insulating portion 80 are formed. The amount (the surface area) of the first conductive layer 51 that is exposed is low because the second portion 82 is provided. Or, the first conductive layer 51 is not exposed.

According to investigations by the inventor, it was found that portions (fragments) of the first conductive layer 51 adhere to the surface of the element when dividing (e.g., dicing) if the surface area of the first conductive layer 51 exposed at the side surface of the element is large. Shorts occur if the fragments, etc., adhere to the pad portion 46, etc. Normal operations are not obtained. The reliability decreases.

In the embodiment, the amount (the surface area) of the first conductive layer 51 that is exposed is low; or the first conductive layer 51 is not exposed. Thereby, stable operations are obtained.

FIG. 4A and FIG. 4B are schematic cross-sectional views illustrating other semiconductor light-emitting elements according to the first embodiment.

These drawings are cross-sectional views corresponding to the line A1-A2 cross section of FIG. 1A.

As shown in FIG. 4A, the second portion 82 of the first insulating portion 80 contacts the first conductive layer 51 in the other semiconductor light-emitting element 111 according to the embodiment. Otherwise, the semiconductor light-emitting element 111 is similar to the semiconductor light-emitting element 110.

In the semiconductor light-emitting element 111 as well, the peeling (the breaking away, etc.) of the portion (the fragment, etc.) of the conductive member used to form the first conductive layer 51 can be suppressed; and stable operations are obtained.

In the semiconductor light-emitting elements 110 and 111, the surface of the second portion 82 on the base body 61 side is substantially parallel to the X-Y plane. The embodiment is not limited thereto; and the surface of the second portion 82 on the base body 61 side may be tilted with respect to the X-Y plane.

In the other semiconductor light-emitting element 112 according to the embodiment as shown in FIG. 4B, which does not form part of the claimed invention, at least a portion of the lower surface (the surface of the second portion 82 on the base body 61 side) of the second portion 82 of the first insulating portion 80 may be tilted with respect to the X-Y plane.

In the semiconductor light-emitting element 112 as well, the peeling (the breaking away, etc.) of the portion (the fragment, etc.) of the conductive member used to form the first conductive layer 51 can be suppressed; and stable operations are obtained.

In the embodiment, it is favorable for at least a portion of the surface of the second portion 82 on the base body 61 side to be substantially parallel to the X-Y plane. Thereby, the configuration of the second portion 82 is stabilized; and the peeling (the breaking away, etc.) of the portion (the fragment, etc.) of the conductive member used to form the first conductive layer 51 can be suppressed more effectively.

### (Second embodiment)

FIG. 5A and FIG. 5B are schematic views illustrating a semiconductor light-emitting element according to a second embodiment.

FIG. 5B is a line A1-A2 cross-sectional view of FIG. 5A. FIG. 5A is a plan view as viewed from the direction of arrow AA shown in FIG. 5B.

FIG. 6 is a schematic cross-sectional view illustrating the semiconductor light-emitting element according to the second embodiment.

FIG. 6 is a line B1-B2 cross-sectional view of FIG. 5A.

As shown in FIG. 5A and FIG. 5B, the semiconductor light-emitting element 120 according to the embodiment also includes the base body 61, the first semiconductor layer 10, the second semiconductor layer 20, the third semiconductor layer 30, the first conductive layer 51, and the first insulating portion 80. For example, the configuration described in reference to the semiconductor light-emitting element 110 is applied to the base body 61, the first semiconductor layer 10, the second semiconductor layer 20, the third semiconductor layer 30, and the first conductive layer 51 of the semiconductor light-emitting element 120. The electrode layer 52, the base body electrode layer 65, and the insulating film 83 are provided in the semiconductor light-emitting element 120 as well. In an embodiment of the claimed invention, the configuration described in reference to the semiconductor light-emitting element 110 is applied to these layers.

In the embodiment of the claimed invention, the first insulating portion 80 includes the first portion 81 recited above and the second portion 82 recited above. Also, the first distance d1 between the first inner side surface 81is and the first outer side surface 81os of the first portion 81 is longer than the second distance d2 between the second inner side surface 82is and the second outer side surface 82os of the second portion 82.

In the semiconductor light-emitting element 120 as well, the first conductive layer 51 includes the first conductive region 51p positioned between the first portion 81 and the base body 61, and the second conductive region 51q positioned between the second portion 82 and the base body 61. In the embodiment of the claimed invention, the second conductive region 51q is not provided; and the base body 61 and at least a portion of the second portion 82 may contact each other.

As shown in FIG. 6, the semiconductor light-emitting element 120 further includes a third conductive layer 43, a third insulating portion 86, a pad portion 47, and a second interconnect 52L.

In the semiconductor light-emitting element 120, the pad portion 47 is electrically connected to the second semiconductor layer 20.

As shown in FIG. 6, at least a portion of the first insulating portion 80 is disposed between the pad portion 47 and the first conductive layer 51. In the example, at least a portion of the first portion 81 of the first insulating portion 80 is disposed between the pad portion 47 and the first conductive layer 51. The second interconnect 52L electrically connects the pad portion 47 and the second semiconductor layer 20. The electrode layer 52 is provided in the example. The second interconnect 52L electrically connects the pad portion 47 and the electrode layer 52. At least a portion of the second interconnect 52L is provided between the pad portion 47 and the first conductive layer 51.

Also, the first semiconductor layer 10 includes the first semiconductor region 10p and the second semiconductor region 10q. The second semiconductor region 10q is arranged with the first semiconductor region 10p in a direction (e.g., the X-axis direction) intersecting the first direction (the Z-axis direction).

The second semiconductor layer 20 overlaps the first semiconductor region 10p in the first direction (the Z-axis direction).

The third conductive layer 43 is provided between the second semiconductor region 10q and the first conductive layer 51. The third conductive layer 43 electrically connects the second semiconductor region 10q and the first conductive layer 51.

The third insulating portion 86 is provided between the second semiconductor layer 20 and the first conductive layer 51. In the example, the electrode layer 52 is provided; and the third insulating portion 86 is provided between the electrode layer 52 and the first conductive layer 51.

Further, as shown in FIG. 6, the third insulating portion 86 extends in at least a portion of the region between the first conductive layer 51 and the second interconnect 52L.

For example, the base body 61 is conductive. In such a case, the first conductive layer 51 electrically connects the first semiconductor layer 10 and the base body 61.

In other words, in the semiconductor light-emitting element 120, the pad portion 47 is an electric terminal on the second conductivity-type side (the p-side); and the base body electrode layer 65 is an electric terminal on the first conductivity-type side (the n-side). The semiconductor light-emitting element 120 is, for example, a lateral-conduction LED.

The semiconductor light-emitting element 120 can be manufactured by, for example, appropriately modifying the example of the method for manufacturing the semiconductor light-emitting element 110 described above.

FIG. 7A and FIG. 7B are schematic cross-sectional views illustrating other semiconductor light-emitting elements according to the second embodiment.

These drawings are cross-sectional views corresponding to the line A1-A2 cross section of FIG. 5A.

In the other semiconductor light-emitting element 121 according to the embodiment of the claimed invention as shown in FIG. 7A, the second portion 82 of the first insulating portion 80 contacts the first conductive layer 51. Otherwise, the semiconductor light-emitting element 121 is similar to the semiconductor light-emitting element 120. In the semiconductor light-emitting element 121 as well, the peeling (the breaking away, etc.) of the portion (the fragment, etc.) of the conductive member used to form the first conductive layer 51 can be suppressed; and stable operations are obtained.

In the semiconductor light-emitting elements 120 and 121, the surface of the second portion 82 on the base body 61 side is substantially parallel to the X-Y plane.

In the other semiconductor light-emitting element 122 according to the embodiment as shown in FIG. 7B, which not form part of the claimed invention, at least a portion of the lower surface of the second portion 82 of the first insulating portion 80 (the surface of the second portion 82 on the base body 61 side) may be tilted with respect to the X-Y plane. In the semiconductor light-emitting element 122 as well, the peeling (the breaking away, etc.) of the portion (the fragment, etc.) of the conductive member used to form the first conductive layer 51 can be suppressed; and stable operations are obtained.

### (Third embodiment)

FIG. 8A and FIG. 8B are schematic views illustrating a semiconductor light-emitting element according to a third embodiment.

FIG. 8B is a line A1-A2 cross-sectional view of FIG. 8A. FIG. 8A is a plan view as viewed from the direction of arrow AA shown in FIG. 8B.

As shown in FIG. 8A and FIG. 8B, the semiconductor light-emitting element 130 according to the embodiment also includes the base body 61, the first semiconductor layer 10, the second semiconductor layer 20, the third semiconductor layer 30, the first conductive layer 51, and the first insulating portion 80. For example, the configuration described in reference to the semiconductor light-emitting element 110 is applied to the base body 61, the first semiconductor layer 10, the second semiconductor layer 20, the third semiconductor layer 30, and the first conductive layer 51 of the semiconductor light-emitting element 130. The electrode layer 52, the base body electrode layer 65, and the insulating film 83 are provided in the semiconductor light-emitting element 130 as well. For example, the configuration described in reference to the semiconductor light-emitting element 110 is applied to these layers.

In the example as well, the first insulating portion 80 includes the first portion 81 recited above and the second portion 82 recited above. Also, the first distance d1 between the first inner side surface 81is and the first outer side surface 81os of the first portion 81 is longer than the second distance d2 between the second inner side surface 82is and the second outer side surface 82os of the second portion 82.

In the semiconductor light-emitting element 130 as well, the first conductive layer 51 includes the first conductive region 51p positioned between the first portion 81 and the base body 61, and the second conductive region 51q positioned between the second portion 82 and the base body 61. In an embodiment of the claimed invention, the second conductive region 51q is not provided; and the base body 61 and at least a portion of the second portion 82 may contact each other.

The semiconductor light-emitting element 130 further includes an electrode 44. The electrode 44 is electrically connected to the first semiconductor layer 10. The first semiconductor layer 10, the second semiconductor layer 20, and the third semiconductor layer 30 are disposed between the electrode 44 and the first conductive layer 51. The second semiconductor layer 20 is electrically connected to the first conductive layer 51. In the example, the electrode layer 52 is provided; and the electrode layer 52 is electrically connected to the second semiconductor layer 20 and the first conductive layer 51.

The semiconductor light-emitting element 130 is, for example, a vertical-conduction LED. In the semiconductor light-emitting element 130, the electrode 44 is an electric terminal on the first conductivity-type side (the n-side); and the base body electrode layer 65 is an electric terminal on the second conductivity-type side (the p-side).

### (Fourth embodiment)

FIG. 9A and FIG. 9B are schematic views illustrating a semiconductor light-emitting element according to a fourth embodiment.

FIG. 9B is a line A1-A2 cross-sectional view of FIG. 9A. FIG. 9A is a plan view as viewed from the direction of arrow AA shown in FIG. 9B.

As shown in FIG. 9A and FIG. 9B, the semiconductor light-emitting element 140 according to the embodiment also includes the base body 61, the first semiconductor layer 10, the second semiconductor layer 20, the third semiconductor layer 30, the first conductive layer 51, and the first insulating portion 80. For example, the configuration described in reference to the semiconductor light-emitting element 110 is applied to the base body 61, the first semiconductor layer 10, the second semiconductor layer 20, the third semiconductor layer 30, and the first conductive layer 51 of the semiconductor light-emitting element 140. The electrode layer 52 is provided in the semiconductor light-emitting element 140 as well. In an embodiment of the claimed invention, the configuration described in reference to the semiconductor light-emitting element 110 is applied to the electrode layer 52. The insulating film 83 may be provided in the semiconductor light-emitting element 140 as well.

In the embodiment of the claimed invention, the first insulating portion 80 includes the first portion 81 recited above and the second portion 82 recited above. Also, the first distance d1 between the first inner side surface 81is and the first outer side surface 81os of the first portion 81 is longer than the second distance d2 between the second inner side surface 82is and the second outer side surface 82os of the second portion 82.

In the semiconductor light-emitting element 140 as well, the first conductive layer 51 includes the first conductive region 51p positioned between the first portion 81 and the base body 61, and the second conductive region 51q positioned between the second portion 82 and the base body 61. In the embodiment of the claimed invention, the second conductive region 51q is not provided; and the base body 61 and at least a portion of the second portion 82 may contact each other.

The semiconductor light-emitting element 140 further includes a fourth semiconductor layer 10a, a fifth semiconductor layer 20a, a sixth semiconductor layer 30a, a third interconnect 55L, a third interconnect insulating film 88, and a fourth insulating portion 87. The fourth semiconductor layer 10a, the fifth semiconductor layer 20a, and the sixth semiconductor layer 30a are included in a stacked body 15a.

The fourth semiconductor layer 10a is separated in the first direction (the Z-axis direction) from a portion of the inner region 61i of the base body 61 (a portion that is different from the portion overlapping the first semiconductor layer 10). The fourth semiconductor layer 10a is arranged with the first semiconductor layer 10 in the direction (in the example, the X-axis direction) intersecting the first direction. The fourth semiconductor layer 10a is of the first conductivity type.

The fifth semiconductor layer 20a is provided between the fourth semiconductor layer 10a and the other portion of the base body 61 recited above. The fifth semiconductor layer 20a is of the second conductivity type.

The sixth semiconductor layer 30a is provided between the fourth semiconductor layer 10a and the fifth semiconductor layer 20a. The sixth semiconductor layer 30a is, for example, a light-emitting layer.

For example, the fourth semiconductor layer 10a includes a semiconductor region 10pa and a semiconductor region 10qa. The semiconductor region 10qa is arranged with the semiconductor region 10pa in a direction intersecting the Z-axis direction. The fifth semiconductor layer 20a is disposed between the base body 61 and the semiconductor region 10pa.

The third interconnect 55L electrically connects the first semiconductor layer 10 and the fifth semiconductor layer 20a. A portion of the third interconnect 55L is provided between the first semiconductor layer 10 and the first conductive layer 51. Another portion of the third interconnect 55L is provided between the fifth semiconductor layer 20a and the base body 61.

In the example, the second conductive layer 42 is provided between the second semiconductor region 10q and the first conductive layer 51 (the base body 61). The third interconnect 55L is electrically connected to the second conductive layer 42. A portion of the third interconnect 55L is disposed between the second conductive layer 42 and the first conductive layer 51.

In the example, a conductive layer 51a is further provided between the fifth semiconductor layer 20a and the base body 61. The other portion of the third interconnect 55L recited above is provided between the fifth semiconductor layer 20a and the conductive layer 51a. The conductive layer 51a includes, for example, a material similar to the first conductive layer 51.

In the example, an electrode layer 52a is provided between the fifth semiconductor layer 20a and the other portion of the third interconnect 55L recited above.

The third interconnect insulating film 88 is provided between the third interconnect 55L and the first conductive layer 51.

The fourth insulating portion 87 is provided between the third interconnect 55L and the base body 61. The fourth insulating portion 87 contacts the base body 61.

The third interconnect insulating film 88 and the fourth insulating portion 87 electrically insulate the third interconnect 55L and the second semiconductor layer 20.

At least a portion of the fourth insulating portion 87 overlaps the region between the first semiconductor layer 10 and the fourth semiconductor layer 10a in the first direction (the Z-axis direction). In the example, the stacked body 15 and the stacked body 15a are connected in series. The stacked body 15 (a first LED) and the stacked body 15a (a second LED) are connected in series by the third interconnect 55L. The base body 61 is insulative in the example.

In the example, an insulating film 84 is provided between the first semiconductor layer 10 and a portion of the third interconnect 55L and between the fourth semiconductor layer 10a and another portion of the third interconnect 55L.

The semiconductor light-emitting element 140 further includes a seventh semiconductor layer 10b, an eighth semiconductor layer 20b, a ninth semiconductor layer 30b, an interconnect 55La, an insulating film 88a, and an insulating portion 87a. The seventh semiconductor layer 10b, the eighth semiconductor layer 20b, and the ninth semiconductor layer 30b are included in a stacked body 15b.

The seventh semiconductor layer 10b is separated in the Z-axis direction from a portion of the inner region 61i of the base body 61. The seventh semiconductor layer 10b is arranged with the semiconductor layer 10 in the X-axis direction. The seventh semiconductor layer 10b is of the first conductivity type.

The eighth semiconductor layer 20b is provided between the seventh semiconductor layer 10b and a portion of the base body 61. The eighth semiconductor layer 20b is of the second conductivity type.

The ninth semiconductor layer 30b is provided between the seventh semiconductor layer 10b and the eighth semiconductor layer 20b. The ninth semiconductor layer 30b is, for example, a light-emitting layer.

For example, the seventh semiconductor layer 10b includes a semiconductor region 10pb and a semiconductor region 10qb. The semiconductor region 10qb is arranged with the semiconductor region 10pb in a direction intersecting the Z-axis direction. The eighth semiconductor layer 20b is disposed between the base body 61 and the semiconductor region 10pb.

The interconnect 55La electrically connects the fourth semiconductor layer 10a and the eighth semiconductor layer 20b. A portion of the interconnect 55La is provided between the fourth semiconductor layer 10a and the first conductive layer 51. Another portion of the interconnect 55La is provided between the eighth semiconductor layer 20b and the base body 61.

In the example, a conductive layer 42a is provided between the semiconductor region 10qa and the base body 61. The interconnect 55La is electrically connected to the conductive layer 42a. A portion of the interconnect 55La is disposed between the conductive layer 42a and the base body 61.

In the example, a conductive layer 51b is further provided between the eighth semiconductor layer 20b and the base body 61. The other portion of the interconnect 55La recited above is provided between the eighth semiconductor layer 20b and the conductive layer 51b. The conductive layer 51b includes, for example, a material similar to the first conductive layer 51.

In the example, an electrode layer 52b is provided between the eighth semiconductor layer 20b and the other portion of the interconnect 55La recited above.

The insulating film 88a is provided between the interconnect 55La and the conductive layer 51a.

The insulating portion 87a is provided between the interconnect 55La and the base body 61. The insulating portion 87a contacts the base body 61.

The insulating film 88a and the insulating portion 87a electrically insulate the interconnect 55La and the fifth semiconductor layer 20a.

In the example, an insulating film 84a is provided between the fourth semiconductor layer 10a and a portion of the interconnect 55La and between the seventh semiconductor layer 10b and another portion of the interconnect 55La.

In the example, a conductive layer 42b is provided between the semiconductor region 10qb and the base body 61. An insulating film 88b is provided between the conductive layer 42b and the conductive layer 51b. An end of an interconnect 55Lb is provided between the conductive layer 42b and the base body 61.

The insulating film 88b electrically insulates the interconnect 55Lb and the eighth semiconductor layer 20b.

In the example, an insulating film 84b is provided between the seventh semiconductor layer 10b and a portion of the interconnect 55Lb.

An end of the interconnect 55Lb is electrically connected to the seventh semiconductor layer 10b (the conductive layer 42b). Another end of the interconnect 55Lb is electrically connected to the pad portion 46.

On the other hand, an end of the second interconnect 52L is electrically connected to the second semiconductor layer 20 (the electrode layer 52). Another end of the second interconnect 52L is electrically connected to the pad portion 47.

In the example, the stacked body 15 (the first LED), the stacked body 15a (the second LED), and the stacked body 15b (a third LED) are connected in series.

The multiple stacked bodies are disposed at high density. By connecting the multiple stacked bodies in series, the voltage that is applied from the outside is applied to the multiple stacked bodies by being subdivided into appropriate values. Thereby, a high efficiency is obtained.

### (Fifth embodiment)

FIG. 10 is a flowchart illustrating a method for manufacturing a semiconductor light-emitting element according to a fifth embodiment.

In the embodiment, the structure body 15s (e.g., referring to FIG. 3C) and the base material 61f (referring to FIG. 3D) are prepared (step S110). The structure body 15s includes the stacked film 15f (referring to FIG. 3A) and a first insulating film (the first portion film 81f illustrated in FIG. 3C). As described above, for example, the structure body 15s may further include the second portion film 82f (referring to FIG. 3C).

The stacked film 15f includes, for example, the first semiconductor film 10f of the first conductivity type, the second semiconductor film 20f of the second conductivity type, and the third semiconductor film 30f provided between the first semiconductor film 10f and the second semiconductor film 20f. The first insulating film (e.g., the first portion film 81f) is provided around the second semiconductor film 20f in a plane (the X-Y plane) intersecting the stacking direction of the stacked film 15f (the first direction, i.e., the Z-axis direction).

The structure body 15s and the base material 61f are bonded (step S120). The bonding is performed with a second insulating film (the second portion film 82f) interposed between the first insulating film (the first portion film 81f) and the base material 61f, and with a conductive film (the first conductive layer 51) interposed between the stacked film 15f and the base material 61f and between the first insulating film and the base material 61f. In other words, the processing described in reference to FIG. 3D is performed.

The stacked film 15f and the base material 61f are cut (divided) (step S130). The cutting is performed in a region (e.g., the dicing street DS illustrated in FIG. 3E) surrounding the second semiconductor film 20f in a plane (e.g., in the X-Y plane) intersecting the stacking direction of the stacked film. In other words, the processing described in reference to FIG. 3E is performed.

According to the embodiment, a method for manufacturing a semiconductor light-emitting element in which stable operations are possible can be provided.

In the embodiment, for example, the second insulating film is provided in the structure body 15s as the second portion film 82f.

The second insulating film may be provided in the base material 61f.

FIG. 11 is a schematic cross-sectional view illustrating the method for manufacturing the semiconductor light-emitting element according to the fifth embodiment.

FIG. 11 illustrates the state before the bonding process illustrated in FIG. 3D.

As shown in FIG. 11, the second insulating film (the second portion film 82f) may be provided at the base material 61f.

Thus, at least a portion of the first insulating portion 80 may be provided at the base material 61f.

For example, there is a Thin Film-type LED in which a semiconductor layer is bonded to a support base body by a bonding metal. In such an LED, there are cases where portions (fragments) of the bonding metal peel and scatter when dicing. Thereby, shorts or leaks occur; and the quality of the LED degrades.

For example, the embodiment recited above can suppress the shorts and the leaks of such a Thin Film-type semiconductor light-emitting element. Also, a high bonding strength is obtained; and high reliability is obtained.

According to the embodiment, the bonding metal is set to be partially thin on the dicing line (the dicing street DS). Thereby, breaking away of the portions (the fragments) of the bonding metal when dicing does not occur easily. Thereby, the shorts and the leaks can be suppressed.

In the embodiment, other than the semiconductors recited above, the semiconductor layer may include a compound semiconductor including at least two of Ga, P, As, or In.

According to the embodiments, a semiconductor light-emitting element and a method for manufacturing the semiconductor light-emitting element are provided in which stable operations are possible.

In the specification, "nitride semiconductor" includes all compositions of semiconductors of the chemical formula B*ₓ*In*_{y}*Al*_{z}*Ga_{1-*x*-*y*-*z*}N (0 ≤ *x* ≤ 1, 0 ≤ *y* ≤ 1, 0 ≤ *z* ≤ 1, and *x*+*y*+*z* ≤ 1) for which the composition ratios x, y, and z are changed within the ranges respectively. "Nitride semiconductor" further includes group V elements other than N (nitrogen) in the chemical formula recited above, various elements added to control various properties such as the conductivity type and the like, and various elements included unintentionally.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, embodiments of the invention are described with reference to specific examples. However, the embodiments of the invention are not limited to these specific examples and are as defined in the appended claims. For example, one skilled in the art may similarly practice the invention by appropriately selecting specific configurations of components included in the semiconductor light-emitting element such as the base body, the semiconductor layer, the conductive layer, the electrode layer, the interconnect, the insulating portion, the insulating film, etc., from known art; and such practice is within the scope of the invention as far as it falls within the scope of the appended claims.

Further, any two or more components of the specific examples may be combined within the extent of technical feasibility and are within the scope of the invention to the extent that they fall within the scope of the appended claims.

Although several embodiments of the invention are described, these embodiments are presented as examples and are not intended to limit the scope of the invention, which defined in the appended claims.

### [Reference Numeral List]

8 substrate
10 first semiconductor layer
10a fourth semiconductor layer
10b seventh semiconductor layer
10dp unevenness
10f first semiconductor film
10p first semiconductor region
10pa, 10pb semiconductor region
10q second semiconductor region
10qa, 10qb semiconductor region
10u upper surface
15, 15a, 15b stacked body
15f stacked film
15s structure body
20 second semiconductor layer
20a fifth semiconductor layer
20b eighth semiconductor layer
20f second semiconductor film
30 third semiconductor layer
30a sixth semiconductor layer
30b ninth semiconductor layer
30f third semiconductor film
42 second conductive layer
42L first interconnect
42a, 42b conductive layer
43 third conductive layer
44 electrode
46 pad portion
47 pad portion
51 first conductive layer
51a, 51b conductive layer
51f first conductive film
51fa metal film
51fb metal film
51p first conductive region
51q second conductive region
52 electrode layer
52L second interconnect
52a, 52b electrode layer
55La, 55Lb interconnect
61 base body
61a first surface
61ap plane
61b second surface
61f base material
61i inner region
61o outer edge region
61s base body side surface
65 base body electrode layer
65f electrode film
80 first insulating portion
81 first portion
81f first portion film
81is first inner side surface
81os first outer side surface
82 second portion
82f second portion film
82is second inner side surface
82os second outer side surface
83 insulating film
84, 84a, 84b insulating film
85 second insulating portion
85a first interconnect insulating film
86 third insulating portion
87 fourth insulating portion
87a insulating portion
88 third interconnect insulating film
88a, 88b insulating film
110 to 112, 120 to 122, 130, 140 semiconductor light-emitting element
AA arrow
DS dicing street
d1 first distance
d2 second distance
d82 distance
t51i conductive portion inner thickness
t51o conductive portion outer edge thickness
t80i insulating portion inner thickness
t80o insulating portion outer edge thickness
t81 first insulating portion thickness
t82 second insulating portion thickness
tp51 first conductive region thickness
tq51 second conductive region thickness
tr51 thickness

## Claims

1. A semiconductor light-emitting element (111, 121, 140), comprising:
a base body (61) having a first surface (61a) and a base body side surface (61s), the first surface (61a) including an outer edge region (61o) and an inner region (61i), the inner region (61i) being on an inner side of the outer edge region (61o), the base body side surface (61s) intersecting the first surface (61a);
a first semiconductor layer (10) of a first conductivity type;
a second semiconductor layer (20) provided between the first semiconductor layer (10) and at least a portion of the inner region (61i), the second semiconductor layer (20) being of a second conductivity type;
a third semiconductor layer (30) provided between the first semiconductor layer (10) and the second semiconductor layer;
a first conductive layer (51); and
a first insulating portion (80),
a portion of the first conductive layer (51) being provided between the base body (61) and the second semiconductor layer (20),
the first insulating portion (80) overlapping the outer edge region (61o) in a first direction, the first direction being from the second semiconductor layer (20) toward the first semiconductor layer (10),
a thickness (t80o) of the first insulating portion (80) at a position overlapping the base body side surface (61s) in the first direction being thicker than a thickness (t80i) of the first insulating portion (80) at a position separated from the base body side surface (61s) in a direction intersecting the first direction,,
wherein the first insulating portion (80) includes:
a first portion (81) overlapping the outer edge region (61o) in the first direction and overlapping the second semiconductor layer (20) in a second direction perpendicular to the first direction; and
a second portion (82) overlapping the outer edge region (61o) in the first direction and overlapping the first conductive layer (51) in the second direction, wherein at least a portion of the second portion (82) of the first insulating portion (80) contacts the base body (61),
wherein the first portion (81) includes:
a first outer side surface (81os) aligned with a second surface (61b), the second surface (61b) including the base body side surface (61s) and intersecting a plane parallel to the first surface (61a); and
a first inner side surface (81is) opposing the second semiconductor layer (20) and intersecting the plane,
wherein the second portion (82) includes:
a second outer side surface (82os) aligned with the second surface (61b); and
a second inner side surface (82is) opposing the first conductive layer (51) and intersecting the plane, and
a first distance (d1) between the first outer side surface (81os) and the first inner side surface (81is) is longer than a second distance (d2) between the second outer side surface (82os) and the second inner side surface (82is), wherein a thickness (t82) of the second portion (82) along the first direction of the second portion (82) is not less than 1.5 times and not more than 10 times a thickness (t81) of the first portion (81) along the first direction of the first portion (81), and
the absolute value of a difference between the first distance (d1) and the second distance (d2) is not less than 2 times and not more than 10 times the thickness (t82) of the second portion (82) along the first direction of the second portion (82).

2. The semiconductor light-emitting element (111, 121, 140) according to claim 1, further comprising a pad portion (46; 47), at least a portion of the first insulating portion (80) being disposed between the pad portion (46; 47) and the first conductive layer (51).

3. The semiconductor light-emitting element (111, 121, 140) according to claim 2, further comprising:
a second conductive layer (42);
a first interconnect (42L) electrically connecting the pad portion (46) and the first semiconductor layer (10); and
a second insulating portion (85),
the first semiconductor layer (10) including:
a first semiconductor region (10p); and
a second semiconductor region (10q) arranged with the first semiconductor region (10p) in a direction intersecting the first direction,
the second semiconductor layer (20) overlapping the first semiconductor region (10p) in the first direction,
the second conductive layer (42) being provided between the second semiconductor region (10q) and the first conductive layer (51),
the second conductive layer (42) being electrically connected to the second semiconductor region (10q),
the second insulating portion (85) being provided between the second conductive layer (42) and the first conductive layer (51).

4. The semiconductor light-emitting element (111, 121, 140) according to claim 3, wherein
the base body (61) is conductive, and
the first conductive layer (51) electrically connects the second semiconductor layer (20) and the base body (61).

5. The semiconductor light-emitting element (111, 121, 140) according to claim 2, further comprising:
a third conductive layer (43);
a second interconnect (52L) electrically connecting the pad portion (47) and the second semiconductor layer (20); and
a third insulating portion (86),
the first semiconductor layer (10) including:
a first semiconductor region (10p); and
a second semiconductor region (10q) arranged with the first semiconductor region (10p) in a direction intersecting the first direction,
the second semiconductor layer (20) overlapping the first semiconductor region (10p) in the first direction,
the third conductive layer (43) being provided between the second semiconductor region (10q) and the first conductive layer (51) and electrically connecting the second semiconductor region (10q) and the first conductive layer (51),
the third insulating portion (86) being provided between the second semiconductor layer (20) and the first conductive layer (51).

6. The semiconductor light-emitting element (111, 121, 140) according to claim 5, wherein the third insulating portion (86) extends in at least a portion between the first conductive layer (51) and the second interconnect (52L) connecting the pad portion (47) and the second semiconductor layer (20).

7. The semiconductor light-emitting element (111, 121, 140) according to anyone of claims 3, 5 or 6, wherein
the base body (61) is conductive, and
the first conductive layer (51) electrically connects the first semiconductor layer (10) and the base body (61).

8. The semiconductor light-emitting element (111, 121, 140) according to claim 4, further comprising an electrode electrically connected to the first semiconductor layer (10),
the first semiconductor layer (10), the second semiconductor layer (20), and the third semiconductor layer (30) being disposed between the electrode and the first conductive layer (51),
the second semiconductor layer (20) being electrically connected to the first conductive layer (51).

9. The semiconductor light-emitting element (140) according to claim 1, further comprising:
a fourth semiconductor layer (10a) of the first conductivity type, the fourth semiconductor layer (10a) being separated in the first direction from another portion of the inner region (61i) and being arranged with the first semiconductor layer (10) in a direction intersecting the first direction;
a fifth semiconductor layer (20a) of a second conductivity type, the fifth semiconductor layer (20a) being provided between the other portion and the fourth semiconductor layer (10a);
a sixth semiconductor layer (30a) provided between the fourth semiconductor layer (10a) and the fifth semiconductor layer (20a);
a third interconnect (55L) electrically connecting the first semiconductor layer (10) and the fifth semiconductor layer (20a), a portion of the third interconnect (55L) being provided between the first semiconductor layer (10) and the first conductive layer (51), another portion of the third interconnect (55L) being provided between the fifth semiconductor layer (20a) and the base body (61);
a third interconnect insulating film (88) provided between the third interconnect (55L) and the first conductive layer (51); and
a fourth insulating portion (87) contacting the base body (61) and being provided between the third interconnect (55L) and the base body (61).

10. The semiconductor light-emitting element (140) according to claim 9, wherein at least a portion of the fourth insulating portion (87) overlaps a region between the first semiconductor layer (10) and the fourth semiconductor layer (10a) in the first direction.

## Patentansprüche

1. Halbleiterlichtemissionselement (111, 121, 140), aufweisend:
einen Grundkörper (61) mit einer ersten Oberfläche (61a) und einer Grundkörper-Seitenoberfläche (61s), wobei die erste Oberfläche (61a) einen äußeren Randbereich (61o) und einen inneren Bereich (61i) beinhaltet, wobei sich der innere Bereich (61i) auf einer Innenseite des äußeren Randbereichs (61o) befindet, wobei die Grundkörper-Seitenoberfläche (61s) die erste Oberfläche (61a) kreuzt;
eine erste Halbleiterschicht (10) eines ersten Leitfähigkeitstyps;
eine zweite Halbleiterschicht (20), die sich zwischen der ersten Halbleiterschicht (10) und zumindest einem Abschnitt des Innenbereichs (61i) befindet, wobei die zweite Halbleiterschicht (20) einem zweiten Leitfähigkeitstyp angehört;
eine dritte Halbleiterschicht (30), die sich zwischen der ersten Halbleiterschicht (10) und der zweiten Halbleiterschicht befindet;
eine erste leitende Schicht (51); und
einen ersten Isolierabschnitt (80);
einen Abschnitt der ersten leitenden Schicht (51), der sich zwischen dem Grundkörper (61) und der zweiten Halbleiterschicht (20) befindet,
wobei sich der erste Isolierabschnitt (80) mit dem äußeren Randbereich (61o) in einer ersten Richtung überlappt, wobei die erste Richtung von der zweiten Halbleiterschicht (20) in Richtung der ersten Halbleiterschicht (10) verläuft,
wobei eine Dicke (t80o) des ersten Isolierabschnitts (80) an einer Position, die sich mit der Grundkörper-Seitenoberfläche (61s) in der ersten Richtung überlappt, dicker ist als eine Dicke (t80i) des ersten Isolierabschnitts (80) an einer Position, die von der Grundkörper-Seitenoberfläche (61s) in einer Richtung getrennt ist, die die erste Richtung schneidet,
wobei der erste Isolierabschnitt (80) beinhaltet:
einen ersten Abschnitt (81), der sich mit dem äußeren Randbereich (61o) in der ersten Richtung überlappt und sich mit der zweiten Halbleiterschicht (20) in einer zweiten Richtung, die zu der ersten Richtung rechtwinklig ist, überlappt; und
einen zweiten Abschnitt (82), der sich mit dem äußeren Randbereich (61o) in der ersten Richtung überlappt und sich mit der ersten leitfähigen Schicht (51) in der zweiten Richtung überlappt, wobei zumindest ein Abschnitt des zweiten Abschnitts (82) des ersten Isolierabschnitts (80) den Grundkörper (61) berührt,
wobei der erste Abschnitt (81) beinhaltet:
eine erste äußere Seitenoberfläche (81os), die auf eine zweite Oberfläche (61b) ausgerichtet ist, wobei die zweite Oberfläche (61b) die Grundkörper-Seitenoberfläche (61s) beinhaltet und eine Ebene kreuzt, die zu der ersten Oberfläche (61a) parallel ist; und
eine erste innere Seitenoberfläche (81is), die der zweiten Halbleiterschicht (20) gegenüberliegt und die Ebene kreuzt,
wobei der zweite Abschnitt (82) beinhaltet:
eine zweite äußere Seitenoberfläche (82os), die auf die zweite Oberfläche (61b) ausgerichtet ist; und
eine zweite innere Seitenoberfläche (82is), die der ersten leitenden Schicht (51) gegenüberliegt und die Ebene kreuzt, und
eine erste Entfernung (d1) zwischen der ersten äußeren Seitenoberfläche (81os) und der ersten inneren Seitenoberfläche (81is) größer ist als eine zweite Entfernung (d2) zwischen der zweiten äußeren Seitenoberfläche (82os) und der zweiten inneren Seitenoberfläche (82is),
wobei eine Dicke (t82) des zweiten Abschnitts (82) entlang der ersten Richtung des zweiten Abschnitts (82) nicht geringer ist als ein 1,5 faches und nicht mehr als ein 10faches einer Dicke (t81) des ersten Abschnitts (81) entlang der ersten Richtung des ersten Abschnitts (81), und
der Absolutwert einer Differenz zwischen der ersten Entfernung (d1) und der zweiten Entfernung (d2) nicht geringer ist als ein 2faches und nicht mehr als ein 10faches der Dicke (t82) des zweiten Abschnitts (82) entlang der ersten Richtung des zweiten Abschnitts (82).

2. Halbleiterlichtemissionselement (111, 121, 140) nach Anspruch 1, ferner aufweisend einen Padabschnitt (46; 47), wobei sich zumindest ein Abschnitt des ersten Isolierabschnitts (80) zwischen dem Padabschnitt (46; 47) und der ersten leitenden Schicht (51) befindet.

3. Halbleiterlichtemissionselement (111, 121, 140) nach Anspruch 2, ferner aufweisend:
eine zweite leitende Schicht (42);
eine erste Verbindung (42L), die den Padabschnitt(46) und die erste Halbleiterschicht (10) elektrisch verbindet; und
einen zweiten Isolierabschnitt (85),
wobei die erste Halbleiterschicht (10) beinhaltet:
einen ersten Halbleiterbereich (10p); und
einen zweiten Halbleiterbereich (10q), der mit dem ersten Halbleiterbereich (10p) in einer Richtung angeordnet ist, die die erste Richtung kreuzt,
wobei sich der zweite Halbleiterbereich (20) mit dem ersten Halbleiterbereich (10p) in der ersten Richtung überlappt,
wobei sich die zweite leitende Schicht (42) zwischen dem zweiten Halbleiterbereich (10q) und der ersten leitenden Schicht (51) befindet,
wobei die zweite leitende Schicht (42) mit dem zweiten Halbleiterbereich (10q) elektrisch verbunden ist,
wobei sich der zweite Isolierabschnitt (85) zwischen der zweiten leitenden Schicht (42) und der ersten leitenden Schicht (51) befindet.

4. Halbleiterlichtemissionselement (111, 121, 140) nach Anspruch 3, wobei
der Grundkörper (61) leitend ist, und
die erste leitende Schicht (51) die zweite Halbleiterschicht (20) und den Grundkörper (61) elektrisch verbindet.

5. Halbleiterlichtemissionselement (111, 121, 140) nach Anspruch 2, ferner aufweisend:
eine dritte leitende Schicht (43);
eine zweite Verbindung (52L), die den Padabschnitt (47) und die zweite Halbleiterschicht (20) elektrisch verbindet; und
einen dritten Isolierabschnitt (86),
wobei die erste Halbleiterschicht (10) beinhaltet:
einen ersten Halbleiterbereich (10p); und
einen zweiten Halbleiterbereich (10q), der mit dem ersten Halbleiterbereich (10p) in einer Richtung angeordnet ist, die die erste Richtung kreuzt,
wobei sich die zweite Halbleiterschicht (20) mit dem ersten Halbleiterbereich (10p) in der ersten Richtung überlappt,
wobei sich die dritte leitende Schicht (43) zwischen dem zweiten Halbleiterbereich (10q) und der ersten leitenden Schicht (51) befindet und den zweiten Halbleiterbereich (10q) und die erste leitende Schicht (51) elektrisch verbindet,
wobei sich der dritte Isolierabschnitt (86) zwischen der zweiten Halbleiterschicht (20) und der ersten leitenden Schicht (51) befindet.

6. Halbleiterlichtemissionselement (111, 121, 140) nach Anspruch 5, wobei der dritte Isolierabschnitt (86) in zumindest einem Abschnitt zwischen der ersten leitenden Schicht (51) und der zweiten Verbindung (52L), die den Padabschnitt (47) und die zweite Halbleiterschicht (20) verbindet, verläuft.

7. Halbleiterlichtemissionselement (111, 121, 140) nach einem der Ansprüche 3, 5 oder 6, wobei
der Grundkörper (61) leitend ist, und
die erste leitende Schicht (51) die erste Halbleiterschicht (10) und den Grundkörper (61) elektrisch verbindet.

8. Halbleiterlichtemissionselement (111, 121, 140) nach Anspruch 4, ferner aufweisend eine Elektrode, die mit der ersten Halbleiterschicht (10) elektrisch verbunden ist,
wobei sich die erste Halbleiterschicht (10), die zweite Halbleiterschicht (20) und die dritte Halbleiterschicht (30) zwischen der Elektrode und der ersten leitenden Schicht (51) befinden,
wobei die zweite Halbleiterschicht (20) mit der ersten leitenden Schicht (51) elektrisch verbunden ist.

9. Halbleiterlichtemissionselement (140) nach Anspruch 1, ferner aufweisend:
eine vierte Halbleiterschicht (10a) des ersten Leitfähigkeitstyps, wobei die vierte Halbleiterschicht (10a) in der ersten Richtung von einem anderen Abschnitt des Innenbereichs (61i) getrennt ist und mit der ersten Halbleiterschicht (10) in einer Richtung, die die erste Richtung kreuzt, angeordnet ist;
eine fünfte Halbleiterschicht (20a) eines zweiten Leitfähigkeitstyps, wobei die fünfte Halbleiterschicht (20a) zwischen dem anderen Abschnitt und der vierten Halbleiterschicht (10a) angeordnet ist;
eine sechste Halbleiterschicht (30a), die sich zwischen der vierten Halbleiterschicht (10a) und der fünften Halbleiterschicht (20a) befindet;
eine dritte Verbindung (55L), die die erste Halbleiterschicht (10) und die fünfte Halbleiterschicht (20a) elektrisch verbindet, wobei sich ein Abschnitt der dritten Verbindung (55L) zwischen der ersten Halbleiterschicht (10) und der ersten leitenden Schicht (51) befindet, wobei sich ein anderer Abschnitt der dritten Verbindung (55L) zwischen der fünften Halbleiterschicht (20a) und dem Grundkörper (61) befindet;
einen Isolierfilm (88) für die dritte Verbindung, der sich zwischen der dritten Verbindung (55L) und der ersten leitenden Schicht (51) befindet; und
einen vierten Isolierabschnitt (87), der den Grundkörper (61) berührt und sich zwischen der dritten Verbindung (55L) und dem Grundkörper (61) befindet.

10. Halbleiterlichtemissionselement (140) nach Anspruch 9, wobei sich zumindest ein Abschnitt des vierten Isolierabschnitts (87) mit einem Bereich zwischen der ersten Halbleiterschicht (10) und der vierten Halbleiterschicht (10a) in der ersten Richtung überlappt.

## Revendications

1. Elément électroluminescent à semi-conducteurs (111, 121, 140), comprenant :
un corps de base (61) comportant une première surface (61a) et une surface latérale de corps de base (61s), la première surface (61a) comprenant une région de bord extérieur (61o) et une région intérieure (61i), la région intérieure (61i) étant d'un côté intérieur de la région de bord extérieur (61o), la surface latérale de corps de base (61s) croisant la première surface (61a) ;
une première couche semi-conductrice (10) d'un premier type de conductivité ;
une deuxième couche semi-conductrice (20) prévue entre la première couche semi-conductrice (10) et au moins une partie de la région intérieure (61i), la deuxième couche semi-conductrice (20) étant d'un deuxième type de conductivité ;
une troisième couche semi-conductrice (30) prévue entre la première couche semi-conductrice (10) et la deuxième couche semi-conductrice ;
une première couche conductrice (51) ; et
une première partie d'isolement (80),
une partie de la première couche conductrice (51) étant prévue entre le corps de base (61) et la deuxième couche semi-conductrice (20),
la première partie d'isolement (80) recouvrant la région de bord extérieur (61o) dans une première direction, la première direction étant de la deuxième couche semi-conductrice (20) vers la première couche semi-conductrice (10),
une épaisseur (t80o) de la première partie d'isolement (80) à une position recouvrant la surface latérale de corps de base (61s) dans la première direction étant plus grande qu'une épaisseur (t80i) de la première partie d'isolement (80) à une position séparée de la surface latérale de corps de base (61s) dans une direction croisant la première direction,
dans lequel la première partie d'isolement (80) comprend :
une première partie (81) recouvrant la région de bord extérieur (61o) dans la première direction et recouvrant la deuxième couche semi-conductrice (20) dans une deuxième direction perpendiculaire à la première direction ; et
une deuxième partie (82) recouvrant la région de bord extérieur (61o) dans la première direction et recouvrant la première couche conductrice (51) dans la deuxième direction, dans lequel au moins une partie de la deuxième partie (82) de la première partie d'isolement (80) est en contact avec le corps de base (61),
dans lequel la première partie (81) comprend :
une première surface latérale extérieure (81os) alignée avec une deuxième surface (61b), la deuxième surface (61b) comprenant la surface latérale de corps de base (61s) et croisant un plan parallèle à la première surface (61a) ; et
une première surface latérale intérieure (81is) opposée à la deuxième couche semi-conductrice (20) et croisant le plan,
dans lequel la deuxième partie (82) comprend :
une deuxième surface latérale extérieure (82os) alignée avec la deuxième surface (61b) ; et
une deuxième surface latérale intérieure (82is) opposée à la première couche conductrice (51) et croisant le plan, et
une première distance (d1) entre la première surface latérale extérieure (81os) et la première surface latérale intérieure (81is) est plus grande qu'une deuxième distance (d2) entre la deuxième surface latérale extérieure (82os) et la deuxième surface latérale intérieure (82is),
dans lequel une épaisseur (t82) de la deuxième partie (82) le long de la première direction de la deuxième partie (82) n'est pas inférieure à 1,5 fois et pas supérieure à 10 fois une épaisseur (t81) de la première partie (81) le long de la première direction de la première partie (81), et
la valeur absolue d'une différence entre la première distance (d1) et la deuxième distance (d2) n'est pas inférieure à 2 fois et pas supérieure à 10 fois l'épaisseur (t82) de la deuxième partie (82) le long de la première direction de la deuxième partie (82).

2. Elément électroluminescent à semi-conducteurs (111, 121, 140) selon la revendication 1, comprenant en outre une partie de pastille (46 ; 47), au moins une partie de la première partie d'isolement (80) étant disposée entre la partie de pastille (46 ; 47) et la première couche conductrice (51).

3. Elément électroluminescent à semi-conducteurs (111, 121, 140) selon la revendication 2, comprenant en outre :
une deuxième couche conductrice (42) ;
une première interconnexion (42L) connectant électriquement la partie de pastille (46) et la première couche semi-conductrice (10) ; et
une deuxième partie d'isolement (85),
la première couche semi-conductrice (10) comprenant :
une première région semi-conductrice (10p) ; et
une deuxième région semi-conductrice (10q) agencée avec la première région semi-conductrice (10p) dans une direction croisant la première direction,
la deuxième couche semi-conductrice (20) recouvrant la première région semi-conductrice (10p) dans la première direction,
la deuxième couche conductrice (42) étant prévue entre la deuxième région semi-conductrice (10q) et la première couche conductrice (51),
la deuxième couche conductrice (42) étant connectée électriquement à la deuxième région semi-conductrice (10q),
la deuxième partie d'isolement (85) étant prévue entre la deuxième couche conductrice (42) et la première couche conductrice (51).

4. Elément électroluminescent à semi-conducteurs (111, 121, 140) selon la revendication 3, dans lequel
le corps de base (61) est conducteur, et
la première couche conductrice (51) connecte électriquement la deuxième couche semi-conductrice (20) et le corps de base (61).

5. Elément électroluminescent à semi-conducteurs (111, 121, 140) selon la revendication 2, comprenant en outre :
une troisième couche conductrice (43) ;
une deuxième interconnexion (52L) connectant électriquement la partie de pastille (47) et la deuxième couche semi-conductrice (20) ; et
une troisième partie d'isolement (86),
la première couche semi-conductrice (10) comprenant :
une première région semi-conductrice (10p) ; et
une deuxième région semi-conductrice (10q) agencée avec la première région semi-conductrice (10p) dans une direction croisant la première direction,
la deuxième couche semi-conductrice (20) recouvrant la première région semi-conductrice (10p) dans la première direction,
la troisième couche conductrice (43) étant prévue entre la deuxième région semi-conductrice (10q) et la première couche conductrice (51) et connectant électriquement la deuxième région semi-conductrice (10q) et la première couche conductrice (51),
la troisième partie d'isolement (86) étant prévue entre la deuxième couche semi-conductrice (20) et la première couche conductrice (51).

6. Elément électroluminescent à semi-conducteurs (111, 121, 140) selon la revendication 5, dans lequel la troisième partie d'isolement (86) s'étend dans au moins une partie entre la première couche conductrice (51) et la deuxième interconnexion (52L) connectant la partie de pastille (47) et la deuxième couche semi-conductrice (20).

7. Elément électroluminescent à semi-conducteurs (111, 121, 140) selon l'une quelconque des revendications 3, 5 ou 6, dans lequel
le corps de base (61) est conducteur, et
la première couche conductrice (51) connecte électriquement la première couche semi-conductrice (10) et le corps de base (61).

8. Elément électroluminescent à semi-conducteurs (111, 121, 140) selon la revendication 4, comprenant en outre une électrode connectée électriquement à la première couche semi-conductrice (10),
la première couche semi-conductrice (10), la deuxième couche semi-conductrice (20), et la troisième couche semi-conductrice (30) étant disposées entre l'électrode et la première couche conductrice (51),
la deuxième couche semi-conductrice (20) étant connectée électriquement à la première couche conductrice (51).

9. Elément électroluminescent à semi-conducteurs (140) selon la revendication 1, comprenant en outre :
une quatrième couche semi-conductrice (10a) du premier type de conductivité, la quatrième couche semi-conductrice (10a) étant séparée dans la première direction d'une autre partie de la région intérieure (61i) et étant agencée avec la première couche semi-conductrice (10) dans une direction croisant la première direction ;
une cinquième couche semi-conductrice (20a) d'un deuxième type de conductivité, la cinquième couche semi-conductrice (20a) étant prévue entre l'autre partie et la quatrième couche semi-conductrice (10a) ;
une sixième couche semi-conductrice (30a) prévue entre la quatrième couche semi-conductrice (10a) et la cinquième couche semi-conductrice (20a) ;
une troisième interconnexion (55L) connectant électriquement la première couche semi-conductrice (10) et la cinquième couche semi-conductrice (20a), une partie de la troisième interconnexion (55L) étant prévue entre la première couche semi-conductrice (10) et la première couche conductrice (51), une autre partie de la troisième interconnexion (55L) étant prévue entre la cinquième couche semi-conductrice (20a) et le corps de base (61) ;
un troisième film isolant d'interconnexion (88) prévu entre la troisième interconnexion (55L) et la première couche conductrice (51) ; et
une quatrième partie d'isolement (87) en contact avec le corps de base (61) et prévue entre la troisième interconnexion (55L) et le corps de base (61).

10. Elément électroluminescent à semi-conducteurs (140) selon la revendication 9, dans lequel au moins une partie de la quatrième partie d'isolement (87) recouvre une région entre la première couche semi-conductrice (10) et la quatrième couche semi-conductrice (10a) dans la première direction.
